# EUROPEAN PATENT APPLICATION

(11) **EP 4 693 597 A1**
(43) Date of publication of application: **11.02.2026**
(21) Application number: 24913528.6
(22) Date of filing: 24.12.2024
(51) Int. Cl.: H01M 10/42, H02J 7/00, H01M 10/44, G01R 31/382, H01M 50/503

(54) **SECONDARY BATTERY FIXING JIG, SECONDARY BATTERY CHARGING AND DISCHARGING DEVICE, AND METHOD FOR USING SAME**

(30) Priority: 29.12.2023 KR 20230196728
(71) Applicant: LG Energy Solution, Ltd., Seoul 07335 (KR)
(72) Inventor: YOON, Yeo Kyung, Daejeon 34122 (KR); KIM, Hwi Jung, Daejeon 34122 (KR)
(74) Representative: Goddar, Heinz J.
(86) International application number: PCT/KR2024/021007
(87) International publication number: WO 2025/143737

(57) **Abstract**

The present invention is a secondary battery fixing jig, which comprises: a mounting plate comprising an electrically insulating material and arranged so that the secondary battery is mounted thereon; a plurality of terminal connection parts arranged so that each is electrically connected by direct contact with one of the plurality of electrode terminals; a bus bar mounted on the mounting plate and arranged to electrically connect electrode terminals with the same polarity among the plurality of electrode terminals of the secondary battery; and at least one terminal fixing member configured to be movable along the bus bar and arranged to electrically connect an electrode terminal with the same polarity as that of the electrode terminal connected to the terminal connection part, on the bus bar.

## Description

### Technical Field

The present invention relates to a secondary battery fixing jig, a secondary battery charging and discharging device, and a method of using the same, and more specifically, relates to a secondary battery fixing jig and a secondary battery charging and discharging device, which can also be applied to secondary batteries having electrode terminals formed at various locations and having various sizes without changing designs, and a method of using the same.

This application claims the benefit of priority based on Korean Patent Application No. 10-2023-0196728 dated December 29, 2023, the disclosure of which is incorporated herein by reference in its entirety.

### Background Art

Recently, rechargeable secondary batteries have been widely used as an energy source for wireless mobile devices. In addition, secondary batteries have also attracted attention as an energy source for electric transportation devices, hybrid electric transportation devices, and the like., which are proposed as a solution to air pollution from existing gasoline transportation devices, diesel transportation devices, and the like, using fossil fuels. Therefore, the types of applications that use secondary batteries are very diverse due to the advantages of secondary batteries, and it is expected that secondary batteries will be applied to more fields and products in the future.

Meanwhile, secondary batteries are manufactured through a battery activation step after going through a step of accommodating an electrode assembly in a case and injecting an electrolyte therein. Here, the battery activation step includes a process of mounting the secondary battery in a secondary battery charging and discharging device, and then charging and discharging the secondary battery under conditions necessary for activation.

In addition, secondary batteries are also tested for their performance, where the performance test of secondary batteries uses a secondary battery charging and discharging device when evaluating the overall performance of secondary batteries in the activation step, or secondary batteries as completely manufactured as well as in such an activation step. In this way, for performance test of the secondary battery, the secondary battery is mounted on the charging and discharging device, and then a measuring terminal for measuring electrical characteristics such as voltage, current, or resistance is connected to the electrode terminal to measure the electrical characteristics.

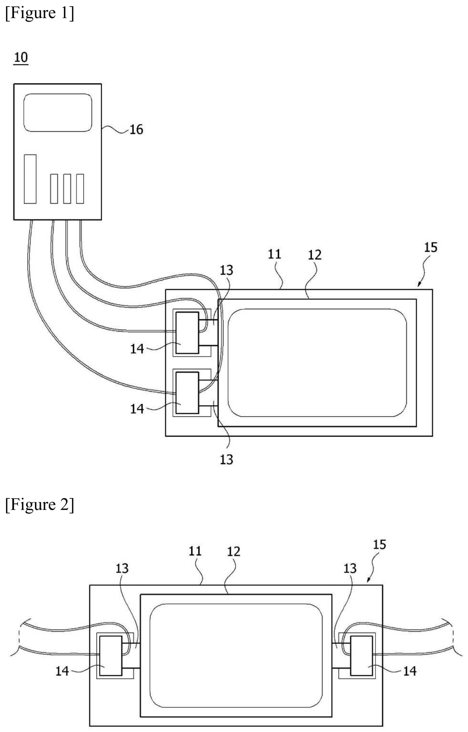

Figure 1 is a schematic diagram schematically showing an appearance of a secondary battery fixing jig (15) and a charging and discharging machine (16) in one type of a conventional art. Then, Figure 2 is a schematic diagram schematically showing an appearance of a secondary battery fixing jig and a charging and discharging machine in another type of a conventional art.

Referring to Figures 1 and 2, a charging and discharging device (10) or a test device for battery activation or testing includes a charging and discharging machine (16), a base (11) for mounting or installing a secondary battery (12), and a fixing jig (15) that is fixed to the base (11) and provided with a terminal connection part (14) for electrically connecting a charging power source, a discharge load, or a resistance measurement terminal to an electrode terminal (13) of the secondary battery (12) mounted on the base (11).

As in Figure 2, the charging and discharging device (10) of the conventional art required a structural change of the fixing jig (15) for changing the position of the terminal connection part (14) according to a size change of the secondary battery (12) or a position change of the electrode terminal (13) in the secondary battery (12).

Meanwhile, the secondary battery that is the target of battery activation or testing may have various sizes depending on the standard, and may also have various protrusion or formation positions of the electrode terminal. Therefore, there is a problem that the size and structure of the fixing jig must be prepared in various ways to match various sizes and electrode terminal structures.

In response to such a problem, Korean Granted Patent No. 10-1790639 (prior patent), could perform charging and discharging and testing of various types of secondary batteries without changing the design of the fixing jig, by inserting a terminal connection hole into a slot at an appropriate depth according to the size of the secondary battery and the structure and direction of the electrode terminal to mount it on a base plate.

However, in the prior patent, in the case of a secondary battery with two or more electrode terminals of the same polarity, it was necessary to additionally install a current cable for applying an electrical current to each additional terminal connection part.

Moreover, the current cable thus added needs to increase an accommodation space in a chamber accommodating the current cable together with the fixing jig, and furthermore, it needs to further form a through-hole in the chamber so that the added current cable can extend to the outside, whereby it is easy to cause the design change of the chamber accommodating the fixing jig depending on the location of the electrode terminal of the secondary battery. Particularly, the cable applying the electrical current becomes thicker and heavier as the electrical current increases, whereby there is a problem that it is difficult to install it in the chamber.

In addition, the prior patent requires two or more electrode terminals to be electrically connected to each other using wires, but if a long electrical path is formed through such long and thin wires, the resistance of the wires increases, whereby there is a limitation to make precise resistance measurement difficult.

There is an urgent need to develop a technology for solving the problems caused by the fixing jig for charging and discharging and performance testing in the activation step of such secondary batteries.

### Disclosure

### Technical Problem

It is an object of the present invention to solve problems caused by a fixing jig for charging and discharging and performance testing in an activation step of a conventional secondary battery.

Through one example of the present invention, it is intended to provide a secondary battery fixing jig capable of performing charging and discharging or testing on all secondary batteries having various sizes and structures.

In addition, through one example of the present invention, it is intended to provide a secondary battery fixing jig without requiring a design change of the fixing jig despite a structural change of a secondary battery.

### Technical Solution

To achieve the above-described objects, according to one example of the present invention, it provides a secondary battery fixing jig in which a charging power source, a discharging load, or an electrical characteristic measurement terminal is connected to a plurality of electrode terminals provided in a secondary battery to be used for charging, discharging, or testing the secondary battery, wherein the secondary battery fixing jig comprises: a mounting plate comprising an electrically insulating material and arranged so that the secondary battery is mounted thereon; a plurality of terminal connection parts arranged so that each is electrically connected by direct contact with one of the plurality of electrode terminals; a bus bar mounted on the mounting plate and arranged to electrically connect electrode terminals with the same polarity among the plurality of electrode terminals of the secondary battery; and at least one terminal fixing member configured to be movable along the bus bar and arranged to electrically connect an electrode terminal with the same polarity as that of the electrode terminal connected to the terminal connection part, on the bus bar.

The mounting plate may be provided with an accommodation part in which a recessed space is formed to accommodate the bus bar, and the recessed space is extended along the extension direction of the bus bar.

The terminal fixing member may be provided with an upper conductive part arranged to be vertically movable so that the electrode terminal is tightly fixed on the bus bar; an adjustment screw part arranged to adjust the vertical position of the upper conductive part; and a moving frame arranged to be movable in a longitudinal direction along an inner surface of the recessed space of the accommodation part.

The plurality of terminal connection parts may comprise a positive terminal connection part provided on one side of the mounting plate and arranged to be connectable to a first positive terminal provided on one side of the secondary battery among the plurality of electrode terminals; and a negative terminal connection part provided on one side of the mounting plate and arranged to be connectable to a first negative terminal provided on one side of the secondary battery among the plurality of electrode terminals.

The bus bar may be arranged to electrically connect the positive terminal connection part and a second positive terminal provided on the other side of the secondary battery among the plurality of electrode terminals, or to connect the negative terminal connection part and a second negative terminal provided on the other side of the secondary battery among the plurality of electrode terminals.

The terminal fixing member may comprise a positive terminal fixing member arranged to fix the second positive terminal to the bus bar, or may comprise a negative terminal fixing member provided to fix the second negative terminal to the bus bar.

The secondary battery may be provided with the first positive terminal and the first negative terminal on one side, and the positive terminal connection part may be connected to the first positive terminal, and the negative terminal connection part may be connected to the first negative terminal.

The secondary battery may be provided with the first negative terminal on one side and the second positive terminal on the other side, the negative terminal connection part may be connected to the first negative terminal, the bus bar may electrically connect the positive terminal connection part and the second positive terminal, and the positive terminal fixing member may fix the second positive terminal to the bus bar.

The secondary battery may be provided with the first positive terminal on one side and the second negative terminal on the other side, the positive terminal connection part may be connected to the first positive terminal, the bus bar may electrically connect the negative terminal connection part and the second negative terminal, and the negative terminal fixing member may fix the second negative terminal to the bus bar.

The secondary battery may be provided with the first positive terminal and the first negative terminal on one side, and the second positive terminal on the other side, the positive terminal connection part may be connected to the first positive terminal, the negative terminal connection part may be connected to the first negative terminal, the bus bar may electrically connect the positive terminal connection part and the second positive terminal, and the positive terminal fixing member may fix the second positive terminal to the bus bar.

The secondary battery may be provided with the first positive terminal and the first negative terminal on one side, and the second negative terminal on the other side, the positive terminal connection part may be connected to the first positive terminal, the negative terminal connection part may be connected to the first negative terminal, the bus bar may electrically connect the negative terminal connection part and the second negative terminal, and the negative terminal fixing member may fix the second negative terminal to the bus bar.

The bus bar may have a linearly extended structure when the first positive terminal and the second positive terminal are positioned in parallel or the first negative terminal and the second negative terminal are positioned in parallel.

The bus bar may have a bent structure when the first positive terminal and the second positive terminal are positioned not to be in parallel or the first negative terminal and the second negative terminal are positioned not to be in parallel.

The secondary battery may be provided with a first positive terminal and a first negative terminal provided on one side, and a second positive terminal and a second negative terminal provided on the other side, the terminal connection parts may comprise a positive terminal connection part arranged to be connected to the first positive terminal, and a negative terminal connection part arranged to be connected to the first negative terminal, the bus bar may comprise a positive bus bar arranged to electrically connect the first positive terminal and the second positive terminal, and a negative bus bar arranged to electrically connect the first negative terminal and the second negative terminal, and the terminal fixing member may comprise a positive terminal fixing member arranged to fix the second positive terminal to the bus bar, and a negative terminal fixing member arranged to fix the second negative terminal to the bus bar.

The positive bus bar and the negative bus bar may have a linearly extended structure when the first positive terminal and the second positive terminal are positioned in parallel or the first negative terminal and the second negative terminal are positioned in parallel.

The terminal connection part may be provided with an upper pressurization plate enabling to move up and down, and arranged to pressurize downwardly the upper surface of the electrode terminal; an adjustment part arranged to adjust a vertical position of the upper pressurization plate; and a lower conductive plate pressurizing upwardly the electrode terminal and arranged so that a current cable arranged to apply an electrical current to the electrode terminal is connected.

To achieve the above-described objects, according to one example of the present invention, it provides a secondary battery charging and discharging device comprising the secondary battery fixing jig, and a charging and discharging machine electrically connected to the terminal connection part and arranged to perform charging, discharging, or testing of a secondary battery.

To achieve the above-described objects, according to one example of the present invention, it provides a method for performing charging and discharging for battery activation and performance test of a secondary battery provided with a plurality of electrode terminals using a secondary battery charging and discharging device, wherein the method comprises: a mounting step of mounting the secondary battery on a mounting plate; a connecting step of connecting the terminal connection part with an electrode terminal provided on one side of the secondary battery; a fixing step of fixing an electrode terminal having the same polarity as that of the electrode terminal provided on one side, and provided on the other side of the secondary battery, on a bus bar using the terminal fixing member; and a charging and discharging step of performing charging and discharging for battery activation in a process of manufacturing the secondary battery, or a resistance measuring step of measuring an internal resistance of the secondary battery.

### Advantageous Effects

As discussed above, the secondary battery fixing jig related to one example of the present invention comprises a bus bar mounted on the mounting plate and arranged to electrically connect electrode terminals with the same polarity, and at least one terminal fixing member configured to be movable along the bus bar and arranged to fix the electrode terminals on the bus bar.

Therefore, by electrically connecting the electrode terminals (13) with the same polarity using the bus bar (130), the increase in the measurement resistance due to the connecting member can be minimized, so that there is an advantage that precise resistance measurement is easy.

Moreover, by electrically connecting the electrode terminals (13) of the same polarity through the bus bar (130), there is no need to install a separate current application cable and a sensing cable in the terminal fixing member (140), so that there is an advantage that the design change of the chamber accommodating the fixing jig is unnecessary.

### Description of Drawings

Figure 1 is a schematic diagram schematically showing an appearance of a secondary battery fixing jig and a charging and discharging machine in one type of a conventional art.
Figure 2 is a schematic diagram schematically showing an appearance of a secondary battery fixing jig and a charging and discharging machine in another type of a conventional art.
Figure 3 is a schematic diagram schematically showing an appearance of a secondary battery fixing jig and a charging and discharging machine according to one example of the present invention.
Figure 4 is a perspective diagram schematically showing an appearance of a secondary battery fixing jig according to one example of the present invention.
Figure 5 is a plan view schematically showing an appearance of a secondary battery fixing jig according to one example of the present invention.
Figure 6 is a plan view schematically showing an appearance that a secondary battery according to one example of the present invention is mounted on a secondary battery fixing jig.
Figure 7 is a partial perspective diagram schematically showing a partial appearance of a secondary battery fixing jig according to one example of the present invention.
Figure 8 is a partial cross-sectional diagram schematically showing a partial appearance of a secondary battery fixing jig according to one example of the present invention.
Figures 9 and 10 are plan views schematically showing appearances of a secondary battery and a fixing jig according to another example of the present invention.
Figure 11 is a plan view schematically showing an appearance of a secondary battery fixing jig according to another example of the present invention.
Figure 12 is a plan view schematically showing an appearance that a secondary battery according to another example of the present invention is mounted on a secondary battery fixing jig.
Figure 13 is a partial side view schematically showing a partial appearance of a secondary battery fixing jig according to one example of the present invention.
Figure 14 is a flow chart showing a method for performing charging and discharging for battery activation or testing of a secondary battery according to one example of the present invention.

### Mode for Invention

Hereinafter, a secondary battery fixing jig and a charging and discharging device according to one example of the present invention will be described in detail with reference to the attached drawings.

In addition, regardless of the reference numerals, the same or corresponding components are given by the same or similar reference numerals, duplicate descriptions thereof will be omitted, and for convenience of explanation, the size and shape of each component member as shown can be exaggerated or reduced.

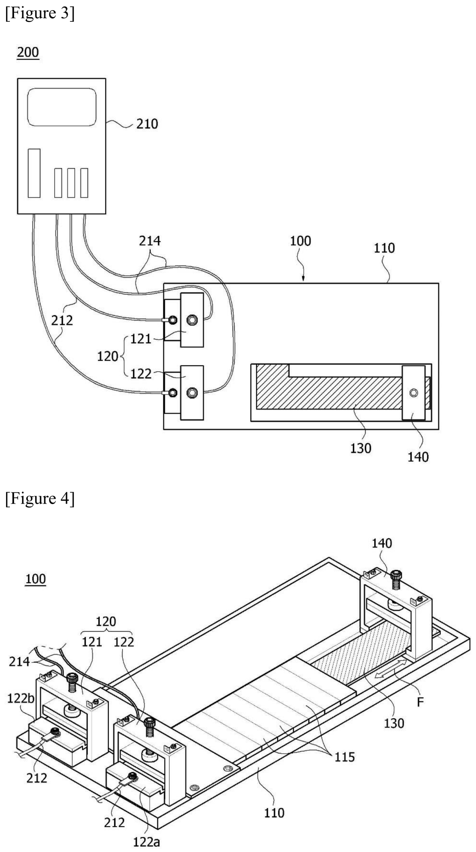

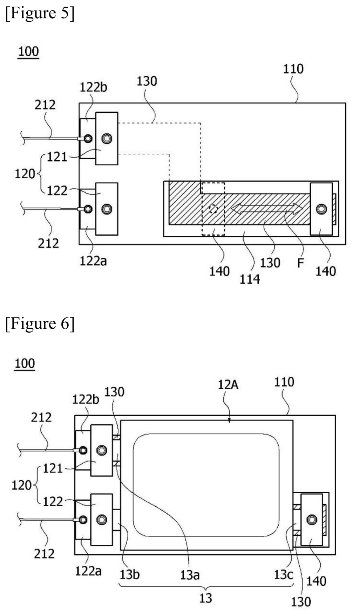

Figure 3 is a schematic diagram schematically showing an appearance of a secondary battery fixing jig (100) and a charging and discharging machine (210) according to one example of the present invention. Figure 4 is a perspective diagram schematically showing an appearance of a secondary battery fixing jig (100) according to one example of the present invention. Figure 5 is a plan view schematically showing an appearance of a secondary battery fixing jig (100) according to one example of the present invention. Then, Figure 6 is a plan view schematically showing an appearance that a secondary battery (12) according to one example of the present invention is mounted on a secondary battery fixing jig (100). For reference, in Figure 5, some components of the bus bar (130) have been shown in dotted lines for the convenience of explanation. However, in Figure 6, for the convenience of drawing explanation, a part of a bus bar (130) embedded in the inside of a mounting plate (110) has been expressed to be visible from the outside.

Referring to Figures 3 to 6, the secondary battery fixing jig (100) according to one example of the present invention may be a jig in which a charging power source, a discharging load, or an electrical characteristic measurement terminal is connected to a plurality of electrode terminals (13) provided in a secondary battery (12, 12A) to be used for charging, discharging, or testing the secondary battery (12, see Figure 1).

Also, the secondary battery fixing jig (100) of the present invention comprises a mounting plate (110). The mounting plate (110) comprises an electrically insulating material. For example, the mounting plate (110) comprises an electrically insulating plastic material. The mounting plate (110) may be arranged so that a secondary battery (12) is mounted on the upper portion. For example, as shown in Figure 3, the mounting plate (110) may have a rectangular plane. The mounting plate (110) may have a predetermined thickness in a vertical direction.

In addition, the mounting plate (110) may be provided with a plurality of insulating covers (115). The insulating cover (115) may have a secondary battery (12) positioned on the upper surface. That is, the insulating cover (115) is arranged to prevent the secondary battery (12) and the bus bar (130) from directly contacting each other, thereby causing a short circuit. The insulating cover (115) may comprise a plastic material that is an electrical insulator. The plurality of insulating covers (115) may be detachably provided on the mounting plate (110). That is, the number of insulating covers (115) may be increased or decreased by the area required for insulation between the secondary battery (12) and the bus bar (130).

Furthermore, the secondary battery fixing jig (100) of the present invention comprises a plurality of terminal connection parts (120). The terminal connection part (120) may be provided to be electrically connected by directly contacting one electrode terminal (13) among the plurality of electrode terminals (13a, 13b, 13c). In addition, the terminal connection part (120) may be electrically connected to a charging and discharging machine (210). The terminal connection part (120) may be electrically connected through a current cable (212), to apply an electrical current supplied from an external device or a charging and discharging machine (210) to the electrode terminal (13) of the secondary battery (12). A sensing cable (214) for measuring resistance may be connected to the terminal connection part (120). The sensing cable (214) may be connected to, for example, a charging and discharging machine (210) capable of measuring resistance or an external resistance measuring device.

Also, the secondary battery fixing jig (100) of the present invention comprises a bus bar (130). The bus bar (130) may be mounted on the mounting plate (110). The bus bar (130) may be arranged so that a portion thereof is embedded in the inside of the mounting plate (110). For example, as in Figure 5, a portion of the bus bar (130) expressed in a dotted line is located inside the mounting plate (110), so that it may not be exposed from the outside. In addition, the bus bar (130) may have a form in which one end extends through the interior space of the mounting plate (110) to the terminal connection part (120), to be electrically connected to the terminal connection part (120). Furthermore, the bus bar (130) may be arranged to electrically connect electrode terminals (13) with the same polarity among the plurality of electrode terminals (13) of the secondary battery (12).

In addition, the bus bar (130) comprises, for example, a copper alloy material. The bus bar (130) may have a predetermined thickness, to minimize resistance. The size of the cross-section perpendicular to the current direction may be set so that the resistance of the bus bar (130) is set in a level of about 1% relative to the resistance of the secondary battery (12).

Therefore, in the secondary battery fixing jig (100) of the present invention, a positive terminal connection part (121) is electrically connected to a first positive terminal (13a) of the secondary battery (12A), a negative terminal connection part (122) is electrically connected to a first negative terminal (13b) of the secondary battery (12A), and the bus bar (130) and a second positive terminal (13c) are electrically connected by pressurization of a terminal fixing member (140), so that even in the secondary battery including three electrode terminals, resistance characteristics or battery performance may be effectively measured.

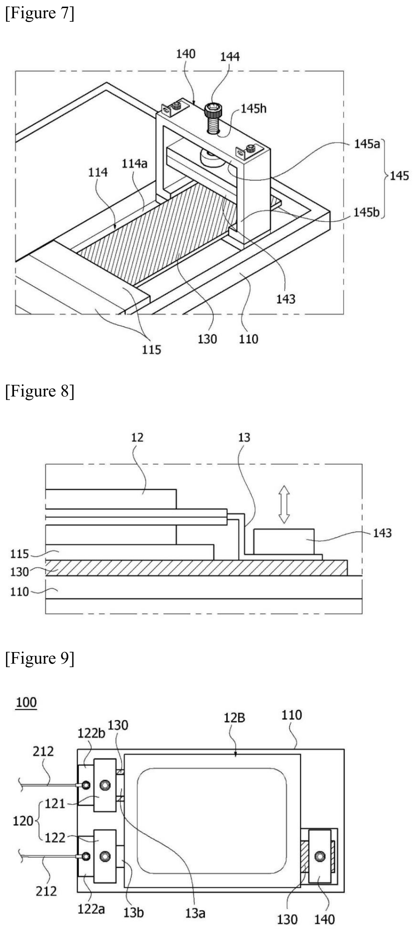

Figure 7 is a partial perspective diagram schematically showing a partial appearance of a secondary battery fixing jig according to one example of the present invention. Figure 8 is a partial cross-sectional diagram schematically showing a partial appearance of a secondary battery fixing jig according to one example of the present invention. For reference, in Figure 8, only an upper conductive part (143) among the components of the terminal fixing member (140) has been shown for drawing explanation.

Referring to Figures 7 and 8 together with Figures 3 to 6, the secondary battery fixing jig (100) of the present invention comprises at least one terminal fixing member (140). The terminal fixing member (140) may be configured to be movable along the extended longitudinal direction (F) of the bus bar (130).

In addition, the terminal fixing member (140) may be arranged to electrically connect an electrode terminal (13) with the same polarity as that of the electrode terminal (13) connected to the terminal connection part (120), on the bus bar (130). For example, as in Figure 7, the terminal fixing member (140) may be arranged to fix the electrode terminal (13) on the bus bar (130) by the pressurization of the upper conductive part (143).

According to such a constitution, the secondary battery fixing jig (100) of the present invention electrically connects the electrode terminals (13a, 13c) with the same polarity using the bus bar (130), thereby enabling to minimize the increase in the measurement resistance due to the connecting member, whereby there is an advantage that precise resistance measurement is easy. Moreover, by electrically connecting the electrode terminals (13) with the same polarity through the bus bar (130), there is no need to install separate current application cables and sensing cables (214) in the terminal fixing member (140), whereby there is an advantage that design changes to a chamber accommodating the fixing jig are unnecessary.

In addition, the secondary battery fixing jig (100) of the present invention may fix the electrode terminal (13) on the bus bar (130) by using the terminal fixing member (140) configured to be movable along the bus bar (130), so that charging and discharging and testing may be performed on secondary batteries (12) with various sizes without changing the structure of the fixing jig.

Meanwhile, referring again to Figure 8 together with Figures 3 to 7, the mounting plate (110) in the secondary battery fixing jig (100) of the present invention is provided with an accommodation part (114) arranged to accommodate the bus bar (130). A space, in which a portion of the upper surface of the mounting plate (110) is recessed downward, may be formed in the accommodation part (114). The recessed depth of the accommodation part (114) may be to the extent that the bus bar (130) may be accommodated. The bus bar (130) may have a form extended along the recessed space of the accommodation part (114). The accommodation part (114) may have a form that the recessed space extends to the terminal connection part (120) so that one end of the bus bar (130) may be connected to the terminal connection part (120). That is, the recessed space (114a) of the accommodation part (114) may have a form extended along the extension direction of the bus bar (130).

Also, the terminal fixing member (140) specifically comprises an upper conductive part (143), an adjustment screw part (144), and a moving frame (145). More specifically, the upper conductive part (143) may be arranged to tightly fix the electrode terminal (13) on the bus bar (130). To this end, the upper conductive part (143) may be arranged to be movable in the vertical direction. The upper conductive part (143) may pressurize the electrode terminal (13) downward so that the electrode terminal (13) is in close contact with the bus bar (130). That is, in such a pressurized state, the electrode terminal (13) may be interposed between the upper conductive part (143) and the bus bar (130).

In addition, the adjustment screw part (144) may be arranged to adjust the vertical position of the upper conductive part (143). For example, a lower end of a screw bolt of the adjustment screw part (144) may be connected to the upper conductive part (143). It may be arranged that upon rotating the screw bolt of the adjustment screw part (144) clockwise, the upper conductive part (143) descends, and on the contrary, upon counterclockwise rotation, the upper conductive part (143) ascends. The screw bolt of the adjustment screw part (144) may have a form inserted through a through-hole of the moving frame (145). A screw thread may be formed on the body of the screw bolt of the adjustment screw part (144), and a screw groove corresponding to the screw thread may be formed on the inner surface of the through-hole of the moving frame (145).

Furthermore, the moving frame (145) may be arranged to be movable in the longitudinal direction along the inner surface of the recessed space (114a) of the accommodation part (114). For example, as illustrated in Figure 8, the moving frame (145) may be provided with a horizontal bar (145a) extending horizontally and leg parts (145b) extending downward from each of both ends of the horizontal bar (145a) and positioned on both sides. A through-hole (145h) into which the adjustment screw part (144) is inserted may be formed in the horizontal bar (145a). The lower end of the leg portion (145b) may be positioned in the recessed space (114a) of the accommodation part (114). The leg part (145b) may be arranged to be movable along the inner surface of the recessed space (114a) of the accommodation part (114). That is, the leg part (145b) may have a width size corresponding to the width in the width direction of the recessed space (114a) of the accommodation part (114).

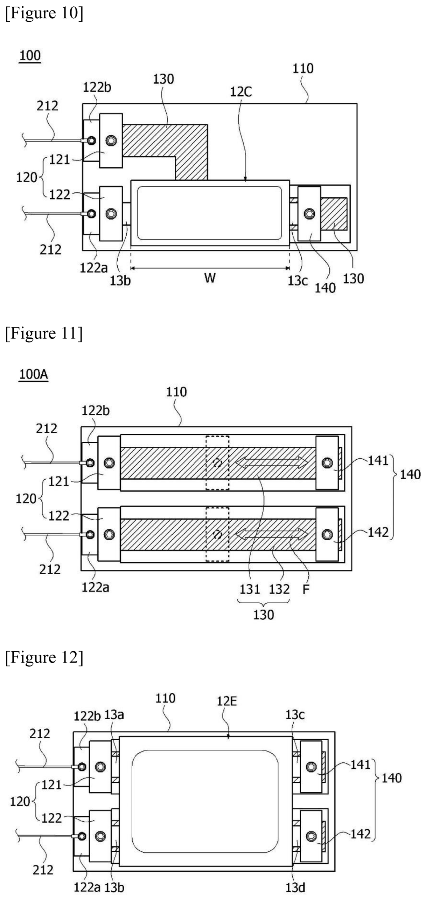

Also, the secondary battery (12) may be provided with an electrode assembly (not shown), a pouch case (12a) accommodating the electrode assembly therein, and a plurality of electrode terminals (13) electrically connected to the electrode assembly and exposed to the outside of the pouch case (12a). For example, the secondary battery (12) may be provided with a first positive terminal (13a) and a first negative terminal (13b) on one side, as shown in Figure 1. For example, the secondary battery (12) may be provided with a first negative terminal (13b) provided on one side and a second positive terminal (13c) provided on the other side, as shown in Figure 10. For example, the secondary battery (12) may be provided with a first negative terminal (13b) provided on one side and a second positive terminal (13c) provided on the other side.

In addition, the plurality of terminal connection parts (120) may comprise a positive terminal connection part (121) and a negative terminal connection part (122). The positive terminal connection part (121) may be provided on one side of the mounting plate (110), and may be arranged to be connectable to the first positive terminal (13a) provided on one side of the secondary battery (12) among the plurality of electrode terminals (13). The negative terminal connection part (122) may be provided on one side of the mounting plate (110), and may be arranged to be connectable to the first negative terminal (13b) provided on one side of the secondary battery (12) among the plurality of electrode terminals (13).

Furthermore, the bus bar (130) may be arranged so that the positive terminal connection part (121) and the second positive terminal (13c) provided on the other side of the secondary battery among the plurality of electrode terminals (13) are electrically connected, or the negative terminal connection part (122) and the second negative terminal (13d) provided on the other side of the secondary battery (12) among the plurality of electrode terminals (13) are connected.

In addition, the terminal fixing member (140) may comprise a positive terminal fixing member (141) arranged to fix the second positive terminal (13c) to the bus bar (130), or may comprise a negative terminal fixing member (142) provided to fix the second negative terminal (13d) to the bus bar (130).

For example, when the secondary battery (12) is provided with the first positive terminal (13a) and the first negative terminal (13b) provided on one side, the positive terminal connection part (121) may be connected to the first positive terminal (13a), and the negative terminal connection part (122) may be connected to the first negative terminal (13b). At this time, the bus bar (130) does not need to be connected to the electrode terminal (13) of the secondary battery (12).

Also, as in Figure 6, when the secondary battery (12) comprises the second positive terminal (13c) provided on the other side together with the first positive terminal (13a) and the first negative terminal (13b) on one side, the positive terminal connection part (121) may be connected to the first positive terminal (13a), and the negative terminal connection part (122) may be connected to the first negative terminal (13b), as in Figure 6. Then, the bus bar (130) may electrically connect the positive terminal connection part (121) and the second positive terminal (13c). That is, one end of the bus bar (130) may be electrically connected to the positive terminal connection part (121) connected to the first positive terminal (13a) of the secondary battery (12), and the other end of the bus bar (130) may be electrically connected to the second positive terminal (13c). The positive terminal fixing member (140) may fix the second positive terminal (13c) to the other end of the bus bar (130).

For example, when the secondary battery (12) comprises the second negative terminal (not shown) provided on the other side together with the first positive terminal (13a) and the first negative terminal (13b) on one side, the positive terminal connection part (121) may be connected to the first positive terminal (13a), and the negative terminal connection part (122) may be connected to the first negative terminal (13b). Then, as in Figure 11, the bus bar (130) may electrically connect the negative terminal connection part (122) and the second negative terminal (13d). That is, one end of the bus bar (130) may be electrically connected to the negative terminal connection part (122) connected to the first negative terminal (13b) of the secondary battery (12), and the other end of the bus bar (130) may be electrically connected to the second negative terminal (13d). At this time, the negative terminal fixing member (140) may fix the second negative terminal to the other end of the bus bar (130).

Also, although not shown in the drawing, the bus bar (130) may have a linearly extended structure when the first positive terminal (13a) and the second positive terminal (13c) are positioned in parallel or the first negative terminal (13b) and the second negative terminal (13d) are positioned in parallel.

In addition, as in Figure 5, the bus bar (130) may have a bent structure when the first positive terminal (13a) and the second positive terminal (13c) are positioned not to be in parallel in the horizontal direction or the first negative terminal (13b) and the second negative terminal (13d) are positioned not to be in parallel in the horizontal direction.

Figures 9 and 10 are plan views schematically showing appearances of a secondary battery and a fixing jig according to another example of the present invention. For reference, in Figures 9 and 10, a part of the bus bar (130) embedded in the inside of the mounting plate (110) has been expressed to be visible from the outside for convenience of drawing explanation.

First, referring to Figure 9, the secondary battery (12B) according to another example comprises a first positive terminal (13a) and a first negative terminal (13b) provided on one side. Therefore, the secondary battery fixing jig (100) of the present invention is arranged so that the positive terminal connection part (121) and the negative terminal connection part (122) are each connected to the first positive terminal (13a) and the first negative terminal (13b). In this instance, the terminal fixing member (140) is not connected to the electrode terminal (13).

Referring to Figure 10, the secondary battery (12C) according to another example comprises a first negative terminal (13b) provided on one side and a second positive terminal (13c) provided on the other side. In addition, the secondary battery (12C) of Figure 10 has a small size in the width direction (W) relative to the secondary battery (12B) of Figure 9. Therefore, the secondary battery fixing jig (100) of the present invention is arranged so that the negative terminal connection part (122) is connected to the first negative terminal (13b) provided on one side, and the bus bar (130) is connected to the second positive terminal (13c) provided on the other side by the pressurization of the terminal fixing member (140) moved in the width direction (W).

For example, as in Figure 10, when the secondary battery (12) is provided with a first negative terminal (13b) on one side and a second positive terminal (13c) on the other side, the negative terminal connection part (122) may be connected to the first negative terminal (13b), and the positive terminal fixing member (141) may fix the second positive terminal (13c) to the surface of the bus bar (130) connected to the positive terminal connection part (121).

For example, when the secondary battery (12) is provided with a first positive terminal (13a) provided on one side and a second negative terminal (13d) provided on the other side, the positive terminal connection part (121) may be connected to the first positive terminal (13a), and the negative terminal fixing member (142) may fix the second negative terminal (13d) to the surface of the bus bar (130) connected to the negative terminal connection part (122).

Therefore, the secondary battery fixing jig (100) of the present invention has an advantage that it is available for all cases where the secondary battery (12) comprises a first positive terminal (13a) and a first negative terminal (13b) provided on one side, or comprises a first negative terminal (13b) provided on one side and a second positive terminal (13c) provided on the other side, or comprises a first positive terminal (13a) and a first negative terminal (13b) provided on one side, and a second positive terminal (13c) provided on the other side, so that it is convenient because a design change of the fixing jig is unnecessary.

Figure 11 is a plan view schematically showing an appearance of a secondary battery fixing jig (100A) according to another example of the present invention. Then, Figure 12 is a plan view schematically showing an appearance that a secondary battery (12) according to another example of the present invention is mounted on a secondary battery fixing jig (100A). The secondary battery fixing jig (100A) of Figures 11 and 12 may further comprise a negative bus bar (132) and a negative terminal fixing member (142) when compared to the secondary battery fixing jig (100) of Figures 5 and 6. Since the remaining constitutions are similar, more detailed descriptions of the remaining constitutions are omitted. For reference, in Figures 11 and 12, a part of the bus bar (130) configured to be covered by an insulating cover (115) has been expressed to be visible from the outside for the convenience of drawing explanation.

Referring to Figures 11 and 12, the secondary battery (12) may comprise a first positive terminal (13a) and a first negative terminal (13b) provided on one side, and a second positive terminal (13c) and a second negative terminal (13d) provided on the other side.

Also, the terminal connection part (120) may comprise a positive terminal connection part (121) arranged to be connectable to the first positive terminal (13a), and a negative terminal connection part (122) provided to be connectable to the first negative terminal (13b).

In addition, the bus bar (130) may comprise at least one of a positive bus bar (131) arranged to electrically connect at least two positive terminals (13a, 13c), and a negative bus bar (132) arranged to electrically connect at least two negative terminals (13b, 13d). For example, as in Figure 11, the secondary battery fixing jig (100A) according to another example of the present invention may comprise a positive bus bar (131) and a negative bus bar (132). The positive bus bar (131) and the negative bus bar (132) may each be electrically connected to the positive terminal connection part (121) and the negative terminal connection part (122), respectively.

Furthermore, the terminal fixing member (140) may comprise a positive terminal fixing member (141) arranged to fix the second positive terminal (13c) to the bus bar (130). The positive terminal fixing member (141) may be arranged to be movable in the longitudinal direction (F) along the positive bus bar (131). The terminal fixing member (140) may comprise a negative terminal fixing member (142) arranged to fix the second negative terminal (13d) to the bus bar (130). The negative terminal fixing member (142) may be arranged to be movable in the longitudinal direction (F) along the negative bus bar (132). At this time, the positive bus bar (131) and the negative bus bar (132) may have a linearly extended structure when the first positive terminal (13a) and the second positive terminal (13c) are positioned in parallel or the first negative terminal (13b) and the second negative terminal (13d) are positioned in parallel.

In addition, when another type secondary battery (12) comprises a first positive terminal provided on one side and a second negative terminal provided on the other side, the first positive terminal (13a) may be connected to the positive terminal connection part (121), and the second negative terminal may be electrically connected to the bus bar (132) connected to the negative terminal connection part (121) by the negative electrode fixing member (142).

Therefore, the secondary battery fixing jig (100A) according to another example of the present invention is available not only in the case where the secondary battery (12) comprises a first positive terminal (13a) and a first negative terminal (13b) provided on one side, but also in the case where the secondary battery (12) comprises a first positive terminal (13a) and a first negative terminal (13b) provided on one side, and a second positive terminal (13c) and a second negative terminal (13d) provided on the other side. Accordingly, the secondary battery fixing jig (100A) of the present invention is useful because it allows charging and discharging and testing of secondary batteries (12) with various structures.

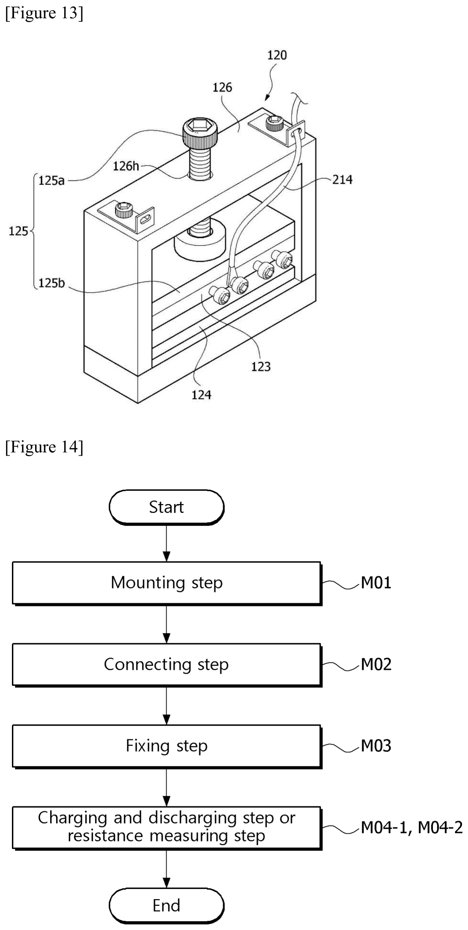

Figure 12 is a partial side view schematically showing a partial appearance of a secondary battery fixing jig (100) according to one example of the present invention. Then, Figure 13 is a partial plan view schematically showing a partial appearance of a secondary battery fixing jig (100) according to one example of the present invention.

Referring to Figures 3 to 6 together with Figures 12 and 13, the terminal connection part (120) comprises an upper pressurization plate (123) and a lower conductive plate (124). Specifically, the upper pressurization plate (123) may be arranged to be movable up and down through an adjustment screw. The upper pressurization plate (123) may be arranged to pressurize the upper surface of the electrode terminal (13) downward. The upper pressurization plate (123) may be connected to a voltage sensing cable (214). At this time, the voltage sensing cable (214) may be connected to a charging and discharging machine (210) or a resistance meter.

Also, the terminal connection part (120) may comprise an adjustment part (125) arranged to adjust the vertical position of the upper pressurization plate (123). The adjustment part (125) may be provided with an adjustment screw (125a). The adjustment part (125) may have a connection block (126b) coupled to the end of the control screw (125a). The lower portion of the connection block (126b) may be coupled to the upper pressurization plate (123).

In addition, the terminal connection part (120) may comprise a connection frame (126) that a through-hole (126h), through which the control screw of the adjustment part (125) is inserted, is formed thereon. The connection frame (126) may be provided with an electrically insulating material.

Furthermore, the lower conductive plate (124) may be arranged to pressurize the electrode terminal (13) upward. As in Figure 6, the lower conductive plate (124) of each of the positive terminal connection part (121) and the negative terminal connection part (122) may be electrically connected to the connection part (122a, 122b) to which a current cable (212) arranged to apply an electrical current to the electrode terminal (13) is connected. At this time, the current cable (212) may be connected to a charging and discharging machine (210) or a resistance meter.

Meanwhile, the present invention provides a secondary battery charging and discharging device (200) according to one example of the present invention. Specifically, the secondary battery charging and discharging device (200) comprises a secondary battery fixing jig (100), and a charging and discharging machine (210) electrically connected to the terminal connection part (120) and arranged to perform charging, discharging, or testing of the secondary battery (12).

Figure 14 is a flow chart showing a method for performing charging and discharging for battery activation or testing of a secondary battery according to one example of the present invention.

Referring again to Figure 14 together with Figures 3 to 6, the present application provides a method for performing charging and discharging for battery activation or testing of a secondary battery (12) using the secondary battery charging and discharging device (200) according to one example of the present invention. Specifically, the method according to one example of the present invention comprises a mounting step (M01). The mounting step (M01) is arranged to mount the secondary battery (12) on the mounting plate (110).

Also, the method of the present invention comprises a connecting step (M02). The connecting step (M02) is a step in which the terminal connection part (120) is connected to the electrode terminal (13) provided on one side of the secondary battery (12). For example, as in Figure 6, the positive terminal of the secondary battery (12) may be connected to the positive terminal connection part (121), and the negative terminal may be connected to the negative terminal connection part (122).

In addition, the method of the present invention comprises a fixing step (M03). The fixing step (M03) is a step of fixing the electrode terminal (13) provided on the other side of the secondary battery (12) with the same polarity as that of the electrode terminal (13) provided on one side, on the bus bar (130) using the terminal fixing member (140).

Furthermore, the method of the present invention comprises a charging and discharging step (M04-1) or a resistance measuring step (M04-2). The charging and discharging step (M04-1) is a step of performing charging and discharging for battery activation in a process of manufacturing a secondary battery (12). The resistance measurement step (M04-2) is a step of measuring an internal resistance of the secondary battery (12).

Therefore, the method of the present invention electrically connects the electrode terminals (13) with the same polarity using the bus bar (130), thereby enabling to minimize the increase in the measurement resistance due to the connecting member, whereby there is an advantage that precise resistance measurement is easy. Moreover, in the method of the present invention, by electrically connecting the electrode terminals (13) with the same polarity through the bus bar (130), there is no need to install separate current application cables and sensing cables (214) in the terminal fixing member (140), whereby there is an advantage that design changes to a chamber accommodating the fixing jig are unnecessary.

The preferred examples of the present invention as described above have been disclosed for illustrative purposes, and those skilled in the art having ordinary knowledge of the present invention will be able to make various modifications, changes, and additions within the spirit and scope of the present invention, and such modifications, changes, and additions should be regarded as falling within the scope of the following claims.

### Industrial Applicability

Through one example of the present invention, it can provide a secondary battery fixing jig capable of performing charging and discharging or testing of secondary batteries having various sizes and structures.

## Claims

1. A secondary battery fixing jig in which a charging power source, a discharging load, or an electrical characteristic measurement terminal is connected to a plurality of electrode terminals provided in a secondary battery to be used for charging, discharging, or testing the secondary battery, wherein the secondary battery fixing jig is **characterized by** comprising:
a mounting plate comprising an electrically insulating material and arranged so that the secondary battery is mounted thereon;
a plurality of terminal connection parts arranged so that each is electrically connected by direct contact with one of the plurality of electrode terminals, and is electrically connected to a charging and discharging machine;
a bus bar mounted on the mounting plate and arranged to electrically connect electrode terminals with the same polarity among the plurality of electrode terminals of the secondary battery; and
at least one terminal fixing member configured to be movable along the bus bar and arranged to electrically connect an electrode terminal with the same polarity as that of the electrode terminal connected to the terminal connection part, on the bus bar.

2. The secondary battery fixing jig according to claim 1, **characterized in that**
the mounting plate is provided with
an accommodation part in which a recessed space is formed to accommodate the bus bar, and the recessed space is extended along the extension direction of the bus bar.

3. The secondary battery fixing jig according to claim 2, **characterized in that**
the terminal fixing member is provided with
an upper conductive part arranged to be vertically movable so that the electrode terminal is tightly fixed on the bus bar;
an adjustment screw part arranged to adjust the vertical position of the upper conductive part; and
a moving frame arranged to be movable in a longitudinal direction along an inner surface of the recessed space of the accommodation part.

4. The secondary battery fixing jig according to claim 3, **characterized in that**
the plurality of terminal connection parts comprises:
a positive terminal connection part provided on one side of the mounting plate and arranged to be connectable to a first positive terminal provided on one side of the secondary battery among the plurality of electrode terminals; and
a negative terminal connection part provided on one side of the mounting plate and arranged to be connectable to a first negative terminal provided on one side of the secondary battery among the plurality of electrode terminals,
the bus bar is
arranged to electrically connect the positive terminal connection part and a second positive terminal provided on the other side of the secondary battery among the plurality of electrode terminals, or to connect the negative terminal connection part and a second negative terminal provided on the other side of the secondary battery among the plurality of electrode terminals, and
the terminal fixing member
comprises a positive terminal fixing member arranged to fix the second positive terminal to the bus bar, or comprises a negative terminal fixing member provided to fix the second negative terminal to the bus bar.

5. The secondary battery fixing jig according to claim 4, **characterized in that**
the secondary battery is provided with the first positive terminal and the first negative terminal on one side, and
the positive terminal connection part is connected to the first positive terminal, and the negative terminal connection part is connected to the first negative terminal.

6. The secondary battery fixing jig according to claim 4, **characterized in that**
the secondary battery is provided with the first negative terminal on one side and the second positive terminal on the other side,
the negative terminal connection part is connected to the first negative terminal,
the bus bar electrically connects the positive terminal connection part and the second positive terminal, and
the positive terminal fixing member fixes the second positive terminal to the bus bar.

7. The secondary battery fixing jig according to claim 4, **characterized in that**
the secondary battery is provided with the first positive terminal on one side and the second negative terminal on the other side,
the positive terminal connection part is connected to the first positive terminal,
the bus bar electrically connects the negative terminal connection part and the second negative terminal, and
the negative terminal fixing member fixes the second negative terminal to the bus bar.

8. The secondary battery fixing jig according to claim 4, **characterized in that**
the secondary battery is provided with the first positive terminal and the first negative terminal on one side, and the second positive terminal on the other side,
the positive terminal connection part is connected to the first positive terminal,
the negative terminal connection part is connected to the first negative terminal,
the bus bar electrically connects the positive terminal connection part and the second positive terminal, and
the positive terminal fixing member fixes the second positive terminal to the bus bar.

9. The secondary battery fixing jig according to claim 4, **characterized in that**
the secondary battery is provided with the first positive terminal and the first negative terminal on one side, and the second negative terminal on the other side,
the positive terminal connection part is connected to the first positive terminal,
the negative terminal connection part is connected to the first negative terminal,
the bus bar electrically connects the negative terminal connection part and the second negative terminal, and
the negative terminal fixing member fixes the second negative terminal to the bus bar.

10. The secondary battery fixing jig according to claim 8 or 9, **characterized in that**
the bus bar has
a linearly extended structure when the first positive terminal and the second positive terminal are positioned in parallel or the first negative terminal and the second negative terminal are positioned in parallel.

11. The secondary battery fixing jig according to claim 8 or 9, **characterized in that**
the bus bar has
a bent structure when the first positive terminal and the second positive terminal are positioned not to be in parallel or the first negative terminal and the second negative terminal are positioned not to be in parallel.

12. The secondary battery fixing jig according to claim 3, **characterized in that**
the secondary battery is provided with a first positive terminal and a first negative terminal provided on one side, and a second positive terminal and a second negative terminal provided on the other side,
the terminal connection parts comprise
a positive terminal connection part arranged to be connected to the first positive terminal, and a negative terminal connection part arranged to be connected to the first negative terminal,
the bus bar comprises
a positive bus bar arranged to electrically connect the first positive terminal and the second positive terminal, and a negative bus bar arranged to electrically connect the first negative terminal and the second negative terminal, and
the terminal fixing member comprises
a positive terminal fixing member arranged to fix the second positive terminal to the bus bar, and a negative terminal fixing member arranged to fix the second negative terminal to the bus bar.

13. The secondary battery fixing jig according to claim 12, **characterized in that**
the positive bus bar and the negative bus bar have
a linearly extended structure when the first positive terminal and the second positive terminal are positioned in parallel or the first negative terminal and the second negative terminal are positioned in parallel.

14. The secondary battery fixing jig according to claim 1, **characterized in that**
the terminal connection part is provided with
an upper pressurization plate enabling to move up and down, and arranged to pressurize downwardly the upper surface of the electrode terminal;
an adjustment part arranged to adjust a vertical position of the upper pressurization plate; and
a lower conductive plate pressurizing upwardly the electrode terminal and arranged so that a current cable arranged to apply an electrical current to the electrode terminal is connected.

15. A secondary battery charging and discharging device **characterized by** comprising the secondary battery fixing jig according to claim 1, and a charging and discharging machine electrically connected to the terminal connection part and arranged to perform charging, discharging, or testing of a secondary battery.
